# EUROPÄISCHE PATENTSCHRIFT

(11) **EP 1 528 603 B1**
(45) Veröffentlichungstag und Bekanntmachung des Hinweises auf die Patenterteilung: **15.08.2018**
(21) Anmeldenummer: 04022802.5
(22) Anmeldetag: 24.09.2004
(51) Int. Cl.: H01L 33/50, H01L 33/58

(54) **Lumineszenzdiodenchip**
Light emitting diode
Diode électroluminescente

(30) Priorität: 31.10.2003 DE 10351397
(43) Veröffentlichungstag der Anmeldung: 04.05.2005
(73) Patentinhaber: OSRAM Opto Semiconductors GmbH, 93055 Regensburg (DE)
(72) Erfinder: Grötsch, Stefan, 93077 Lengfeld/Bad Abbach (DE); Brunner, Herbert, 93161 Sinzing (DE); Ott, Hubert, 93077 Bad Abbach (DE)
(74) Vertreter: Epping - Hermann - Fischer

(56) Entgegenhaltungen:
- EP-A1- 1 119 058
- EP-A2- 1 081 771
- EP-A2- 1 191 608
- DE-A1- 10 137 641
- JP-A- 10 151 794
- JP-A- 2000 022 222
- JP-A- 2003 101 074

## Beschreibung

Die Erfindung betrifft einen Lumineszenzdiodenchip mit einem Halbleiterkörper, der eine epitaktisch gewachsene Halbleiterschichtenfolge mit einer aktiven Zone und eine Strahlungsauskoppelfläche aufweist, wobei die aktive Zone bei Betrieb des Lumineszenzdiodenchips eine elektromagnetische Strahlung emittiert, die zumindest teilweise über die Strahlungsauskoppelfläche ausgekoppelt wird.

Lumineszenzdiodenchips werden in der Regel mittels einer Kapselmasse eingekapselt, was u.a. eine verbesserte Strahlungsauskopplung der elektromagnetischen Strahlung an die Umgebung bewirkt. Hierzu werden die Lumineszenzdiodenchips oftmals in ein Gehäuse montiert, elektrisch leitend kontaktiert und nachfolgend mit einer Vergußmasse vergossen, wodurch das resultierende Bauelement verglichen mit dem Lumineszenzdiodenchip relativ groß wird.
Desweiteren ist bekannt einem Lumineszenzdiodenchip in einer Aabstrahlrichtung ein Lumineszenz-Konversionsmaterial nachzuordnen. Unter einem Lumineszenz-Konversionsmaterial ist ein Material zu verstehen, das Bestandteile aufweist, mittels denen eine von der Halbleiterschichtenfolge bei Betrieb des Lumineszenzdiodenchips ausgesandte elektromagnetische Strahlung in eine Strahlung veränderter Wellenlänge konvertierbar ist.
Das Lumineszenz-Konversionsmaterial wird meist mit einer Kapselmasse zum Einkapseln des Lumineszenzdiodenchips vermischt. Darüber hinaus ist beispielsweise in der WO 01/65613 ein lichtabstrahlendes Halbleiterbauelement mit einem Lumineszenz-Konversionselement beschrieben, bei dem ein Lumineszenz-Konversionsmaterial direkt auf mindestens eine Oberfläche eines Halbleiterkörpers aufgebracht wird. Dadurch kann eine unhomogene Verteilung des Lumineszenz-Konversionsmaterials aufgrund von Sedimentationsbildung in einer Kapselmasse weitestgehend vermieden werden.

Eine Aufgabe der vorliegenden Erfindung besteht darin, einen Lumineszenzdiodenchip anzugeben, der bereits Elemente zur verbesserten Strahlungsauskopplung und/oder zur Konversion von elektromagnetischer Strahlung aufweist und somit insbesondere eine weitere Miniaturisierung von Lumineszenz-Bauelementen zulässt.

Die Druckschrift EP 1 191 608 A2 beschreibt ein Licht emittierendes Bauelement mit einer LED, auf der mittels einer transparenten Verbindungsschicht, die ein Lumineszenzkonversionsmaterial enthalten kann, eine transparente Linse befestigt ist.

Die Druckschrift JP 2003-101074 A beschreibt einen LED-Chip, auf dem mittels eines anorganischen Klebstoffs eine Konversionsschicht mit einer Halteplatte auf dieser angeordnet ist.

Die Druckschrift EP 1 081 771 A2 beschreibt ein LED-Package mit LEDs, über denen eine Verkapselungsschicht aus einem Silikongel, eine Leuchtstoffschicht und eine Linse aufgebracht sind.

Diese Aufgabe wird durch einen Lumineszenzdiodenchip mit den Merkmalen des Patentanspruches 1 gelöst. Vorteilhafte Ausführungsformen und bevorzugte Weiterbildungen des Lumineszenzdiodenchips sind in den abhängigen Patentansprüchen 2 bis 15 angegeben.
Erfindungsgemäß weist der Lumineszenzdiodenchip einen strahlungsdurchlässigen Abdeckkörper auf, der der Strahlungsauskoppelfläche in einer Abstrahlrichtung des Lumineszenzdiodenchips nachgeordnet ist und der eine der Strahlungsauskoppelfläche zugewandte erste Hauptfläche, eine der Strahlungsauskoppelfläche abgewandte zweite Hauptfläche sowie die erste und die zweite Hauptfläche verbindende Seitenflächen aufweist. Zwischen der Strahlungsauskoppelfläche und dem Abdeckkörper ist eine Verbindungsschicht angeordnet, die den Abdeckkörper direkt mit der Halbleiterschichtenfolge verbindet und ihn an dieser befestigt. Zudem umfasst die Verbindungsschicht mindestens eine Konversionsschicht mit einem Lumineszenz-Konversionsmaterial und eine Klebstoffschicht, wobei die Dicke der Verbindungsschicht maximal 200 µm beträgt. Der Lumineszenzdiodenchip selbst weist vorteilhafterweise bereits Elemente zur verbesserten Strahlungsauskopplung und Strahlungskonversion auf. Verglichen mit herkömmlichen Konversions-Bauelementen sind die Abmessungen des Lumineszenzdiodenchips relativ klein, da der Abdeckkörper und die Verbindungsschicht direkt auf dem Halbleiterkörper angeordnet und befestigt sind. Mit anderen Worten grenzt der Abdeckkörper frei an der Verbindungsschicht an, mittels der er direkt mit dem Halbleiterkörper verbunden ist, und ist nicht etwa durch zusätzliche äußere Halte- und/oder Stützelemente z.B. eines Gehäuses relativ zum Halbleiterkörper fixiert.
Mit dem erfindungsgemäßen Lumineszenzdiodenchip lassen sich kleinere Bauelemente herstellen, die hinsichtlich der Strahlungsauskopplung und/oder der Strahlungskonversion keine wesentlichen Unterschiede zu herkömmlichen Bauelementen aufweisen, aber diesen gegenüber deutlich verkleinert sind. Selbstverständlich ist es auch möglich den Lumineszenzdidodenchip wie herkömmliche Chips etwa in ein Gehäuse zu montieren und/oder mit einer Kapselmasse zu verkapseln. Das Gehäuse eines zugehörigen Bauelements muß keine Konversionselemente aufweisen und kann unabhängig von den Konversionserfordernissen optimiert werden. Es können beispielsweise weitere optische Elemente an dem Bauelement angeordnet werden.
Die Verbindungsschicht weist bevorzugt eine Dicke von maximal 80 *µ*m auf. Zusätzlich zu seiner Funktion als Element für eine verbesserte Strahlungsauskopplung ist der Abdeckkörper besonders bevorzugt als strahlungsformendes optisches Element ausgebildet. Je nach konkreter Ausbildung des Abdeckkörpers kann damit z.B. eine weiter erhöhte Strahlungsauskopplung aus dem Lumineszenzdiodenchip oder eine Verringerung der Divergenz von aus dem Lumineszenzdiodenchip ausgekoppelter Strahlung erreicht werden.
Der Abdeckkörper ist hierzu mit Vorteil als Abdeckplatte ausgebildet, bei der die Seitenflächen zumindest teilweise nicht senkrecht zu einer Haupterstreckungsebene der Abdeckplatte verlaufen. Eine derartige Abdeckplatte kann einfach hergestellt und verarbeitet werden.

Die Seitenflächen des Abdeckkörpers sind bevorzugt im wesentlichen parabolisch, hyperbolisch oder elliptisch gekrümmt.

In einer besonderen Ausführungsform ist der Abdeckkörper mit Vorteil als ein CPC-, CEC- oder CHC-artiger optischer Konzentrator ausgebildet, womit hierbei sowie im folgenden ein Konzentrator gemeint ist, dessen reflektierenden Seitenflächen zumindest teilweise und/oder zumindest weitestgehend die Form eines zusammengesetzten parabolischen Konzentrators (Compound Parabolic Concentrator, CPC), eines zusammengesetzten elliptischen Konzentrators (Compound Elliptic Concentrator, CEC) und/oder eines zusammengesetzten hyperbolischen Konzentrators (Compound Hyperbolic Concentrator, CHC) aufweist. Dabei ist die erste Hauptfläche des Abdeckkörpers der eigentliche Konzentratorausgang, so daß Strahlung, verglichen mit der üblichen Anwendung eines Konzentrators zum Fokussieren, in umgekehrter Richtung durch diesen läuft und somit nicht konzentriert wird, sondern den Abdeckkörper mit verringerter Divergenz durch die zweite Hauptfläche verläßt.

Die zweite Hauptfläche des Abdeckkörpers ist bevorzugt zumindest teilweise in der Art einer refraktiven und/oder diffraktiven Linse gekrümmt bzw. strukturiert.

Alternativ oder zusätzlich weist der Abdeckkörper vorteilhafterweise holographische Strukturen oder Elemente auf. Dadurch können mit dem Lumineszenzdiodenchip Muster oder Grafiken projeziert werden.

In einer weiteren vorteilhaften Ausführungsform des Lumineszenzdiodenchips sind zumindest die Seitenflächen des Abdeckkörpers zumindest teilweise mit einer Schicht oder Schichtenfolge, bevorzugt mit einer metallischen Schicht versehen, die für eine von dem Lumineszenzdiodenchip bei dessen Betrieb ausgesandte Strahlung reflektierend ist. Dadurch kann erreicht werden, daß ein größerer Anteil von Strahlung in einer gewünschten Abstrahlrichtung aus dem Lumineszenzdiodenchip emittiert wird.
Mit Vorteil ist der Abdeckkörper mit einem Lumineszenz-Konversionsmaterial versetzt. Dieses Lumineszenz-Konversionsmaterial kann ein anderes sein als in der Konversionsschicht.
Zweckmäßigerweise ist der Abdeckkörper im wesentlichen aus einem Material gebildet, dessen Ausdehnungskoeffizient im wesentlichen dem Ausdehnungskoeffizienten eines Materials der Halbleiterschichtenfolge entspricht. Bevorzugt weist der Abdeckkörper ein Material auf, das im wesentlichen aus einem Borosilikatglas besteht oder auf einem Borosilikatglas basiert.

Die Verbindungsschicht weist einen auf Silikon basierenden Klebstoff auf. Ein Vorteil eines auf Silikon basierenden Klebstoffes ist, daß dieser eine relativ geringe Empfindlichkeit gegenüber ultravioletter Strahlung aufweist.
Besonders bevorzugt ist der Lumineszenzdiodenchip ein Dünnfilm-Lumineszenzdiodenchip, der sich insbesondere durch folgende charakteristische Merkmale auszeichnet:
- an einer zu einem Trägerelement hin gewandten ersten Hauptfläche der Halbleiterschichtenfolge ist eine reflektierende Schicht aufgebracht oder ausgebildet, die zumindest einen Teil der in der Halöbleiterschichtenfolge erzeugten elektromagnetischen Strahlung in diese zurückreflektiert;
- die Halbleiterschichtenfolge weist eine Dicke im Bereich von 20 *µ*m oder weniger, insbesondere im Bereich von 10 *µ*m auf; und
- die Halbleiterschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der epitaktischen Epitaxieschichtenfolge führt, d.h. sie weist ein möglichst ergodisch stochastisches Streuverhalten auf.
Ein Grundprinzip eines Dünnfilm-Lumineszenzdiodenchips ist beispielsweise in I. Schnitzer et al., Appl. Phys. Lett. 63 (16), 18. Oktober 1993, 2174 - 2176 beschrieben. Der Lumineszenzdiodenchip ist in einer alternativen Ausführungsform für eine Flip-Chip Montage vorgesehen, was zur Folge hat, daß die Strahlungsauskoppelfläche eine der Halbleiterschichtenfolge gegenüberliegende Außenfläche eines Substrates des Halbleiterkörpers ist. Bei einem Flip-Chip ist die Strahlungsauskoppelfläche frei von elektrischem Kontaktmaterial, so daß der Abdeckkörper flächig über der gesamten Strahlungsauskoppelfläche aufgebracht sein kann.
Weitere Vorteile, bevorzugte Ausführungsformen und Weiterbildungen des Lumineszenzdiodenchips ergeben sich aus den im folgenden in Verbindung mit den Figuren 1 bis 6 erläuterten Ausführungsbeispielen. Es zeigen:
Figur 1 ein erstes Ausführungsbeispiel eines Lumineszenzdiodenchips in schematischer Darstellung;
Figur 2 ein zweites Ausführungsbeispiel eines Lumineszenzdiodenchips in schematischer Darstellung;
Figur 3 ein drittes Ausführungsbeispiel eines Lumineszenzdiodenchips in schematischer Darstellung;
Figur 4 ein viertes Ausführungsbeispiel eines Lumineszenzdiodenchips in schematischer Darstellung;
Figur 5 ein fünftes Ausführungsbeispiel eines Lumineszenzdiodenchips in schematischer Darstellung und
Figur 6 ein sechstes Ausführungsbeispiel eines Lumineszenzdiodenchips in schematischer Darstellung.

In den Ausführungsbeispielen und Figuren sind gleiche oder gleichwirkende Bestandteile jeweils mit den gleichen Bezugszeichen versehen. Die dargestellten Bestandteile sowie die Größenverhältnisse der Bestandteile untereinander sind nicht als maßstabsgerecht anzusehen. Vielmehr sind einige Details der Figuren zum besseren Verständnis übertrieben groß dargestellt.

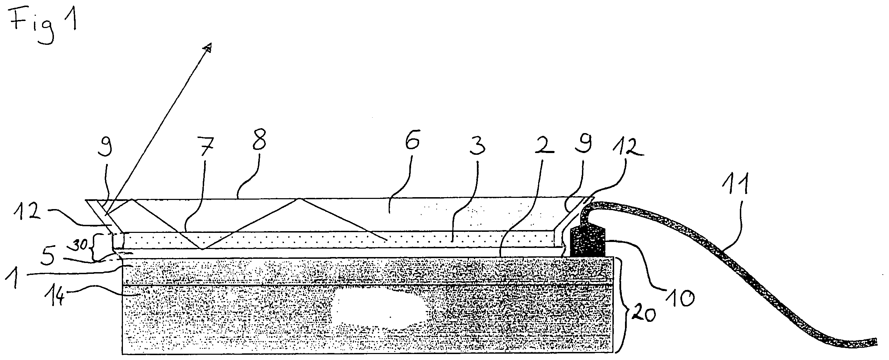

Der in Figur 1 dargestellte Lumineszenzdiodenchip umfasst einen Halbleiterkörper 20, der ein Substrat 14 und eine darauf aufgebrachte epitaktisch gewachsene Halbleiterschichtenfolge 1 aufweist. Die von dem Substrat 14 abgewandte Außenfläche der Halbleiterschichtenfolge 1 ist eine Strahlungsauskoppelfläche 2 des Halbleiterkörpers 20. Auf der Strahlungsauskoppelfläche 2 ist eine Verbindungsschicht 30 angeordnet, die den auf der Verbindungsschicht 30 angeordneten Abdeckkörper 6 mit dem Halbleiterkörper 20 verbindet und an dem Halbleiterkörper 20 befestigt. Die Verbindungsschicht 30 weist in den Ausführungsbeispielen parallel zur Strahlungsauskoppelfläche 2 eine Ausdehnung auf, die in etwa der Ausdehnung der Strahlungsauskoppelfläche entspricht.

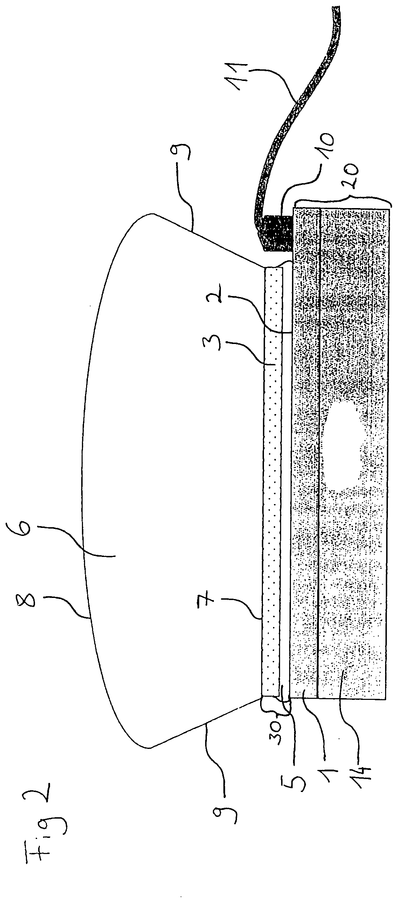

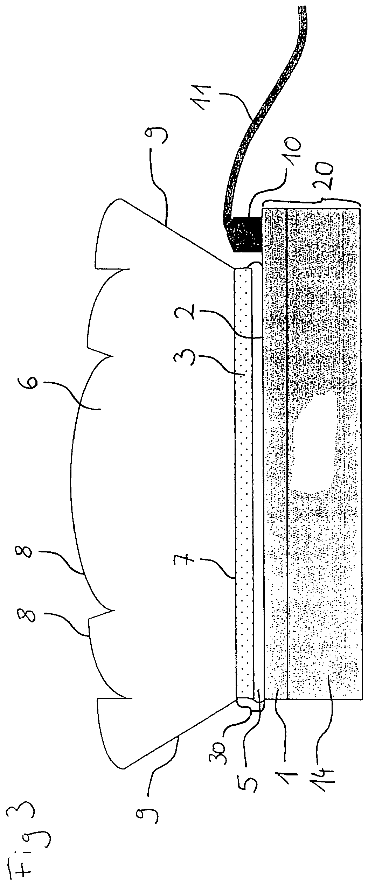

Das Substrat 14 kann ein Aufwachssubstrat sein, was heißt, daß die Halbleiterschichtenfolge 1 direkt auf dem Substrat 14 aufgewachsen ist. Alternativ kann das Substrat 14 auch ein Trägersubstrat sein, wie das beispielsweise bei Dünnfilm-Lumineszenzdiodenchips der Fall ist. Dabei wird zur Herstellung des Halbleiterkörpers 20 die Halbleiterschichtenfolge 1 zunächst auf einem Aufwachssubstrat aufgewachsen und nachfolgend mit der von dem Aufwachssubstrat abgewandten Hauptfläche auf einem Trägersubstrat aufgebracht. Das Aufwachssubstrat wird zumindest teilweise von der Halbleiterschichtenfolge 1 entfernt. Weitere charakteristische Merkmale von Dünnfilm-Lumineszenzdiodenchips sind im allgemeinen Teil der Beschreibung genannt.
Dünnfilm-Lumineszenzdiodenchips weisen eine nahezu lambertsche Abstrahlcharakteristik auf, was besonders vorteilhaft ist, wenn die Strahlungsauskoppelfläche 2 mit einer dünnen Konversionsschicht 3 bedeckt ist, da nahezu die gesamte Strahlung durch die Strahlungsauskoppelfläche 2 und nur ein geringer Anteil seitlich ausgekoppelt wird.
Die Halbleiterschichtenfolge 1 basiert z.B. auf einem Nitrid-Verbindungshalbleitermaterial, d.h. mindestens eine Schicht der Halbleiterschichtenfolge weist ein Material aus dem System InₓAl_{y}Ga_{1-x-y}N mit 0 ≤ x ≤ 1, 0 ≤ y ≤ 1 und x+y ≤ 1 auf. Zudem kann die Halbleiterschichtenfolge 1 beispielsweise eine Multiquantentopfstruktur aufweisen, wie sie etwa in der WO 01/39282 A2 beschrieben ist. Anstelle der Multiquantentopfstruktur kann auch eine Einfachquantentopfstruktur, eine Doppel-Heterostruktur oder eine Single-Heterostruktur verwendet werden.
Der Abdeckkörper 6 weist eine erste Hauptfläche 7, eine zweite Hauptfläche 8 sowie die erste und die zweite Hauptfläche 7, 8 verbindende Seitenflächen 9 auf. Die erste Hauptfläche 7 grenzt an die eine Konversionsschicht 3 der Verbindungsschicht 30 an.
Bei einer Herstellung des Lumineszenzdiodenchips kann beispielsweise die Konversionsschicht 3 auf dem Abdeckkörper 6 aufgebracht werden. Die Konversionsschicht ist dann wiederum mittels eines auf Silikon basierenden Klebstoffes 5 auf der Strahlungsauskoppelfläche 2 aufgebracht. Die erste Hauptfläche des Abdeckkörpers ist zweckmäßigerweise glatt ausgebildet und das Lumineszenz-Konversionsmaterial ist in einer Schicht von hoher Gleichmäßigkeit aufgebracht. Dies kann von Vorteil sein, wenn die Strahlungsauskoppelfläche z.B. aufgerauht ist, wodurch sich eine Konversionsschicht nur begrenzt gleichmäßig aufbringen ließe.
Durch die Verwendung eines Abdeckkörpers zum Aufbringen der Konversionsschicht 3 kann das Aufbringen unter Umständen auch bei Bedingungen durchgeführt werden, die für eine Funktionalität der Halbleiterschichtenfolge schädlich sein könnten, wie z.B. relativ hoher Druck und/oder relativ hohe Temperaturen.
Bei dem in Figur 1 dargestellten Lumineszenzdiodenchip sind die Seitenflächen 9 des Abdeckkörpers 6 und der angrenzenden Konversionsschicht 3 mit einer reflektierenden Schicht oder Schichtenfolge 12, z.B. einer Metallschicht aus Silber versehen. Alternativ können auch nur die Seitenflächen 9 des Abdeckkörpers 6 komplett oder teilweise beschichtet sein.
Durch die reflektierende Beschichtung 12 werden elektromagnetische Strahlen (in Figur 1 dargestellt durch den Pfeil), die ohne die reflektierende Beschichtung 12 seitlich aus dem Abdeckkörper 6 ausgekoppelt würden, wieder zurückreflektiert. Die abgeschrägten Seitenflächen 9 des Abdeckkörpers 6 bewirken, daß ein großer Teil von elektromagnetischen Strahlen, die aufgrund von mehrfacher interner Totalreflexion in dem Abdeckkörper 6 und der Konversionsschicht 3 gehalten werden, derart zur Strahlungsaufkoppelfläche 8 reflektiert werden, daß sie an dieser aus dem Abdeckkörper 6 auskoppeln.
Die Konversionsschicht 3 weist ein Lumineszenz-Konversionsmaterial auf, das z.B. aus mindestens einem Leuchtstoffbesteht. Dazu eignen sich beispielsweise anorganische Leuchtstoffe, wie mit seltenen Erden (insbesondere Ce) dotierte Granate, oder organische Leuchtstoffe, wie Perylen-Leuchtstoffe. Weitere geeignete Leuchtstoffe sind beispielsweise in der WO 98/12757 aufgeführt. Das Lumineszenz-Konversionsmaterial kann in einem Matrixmaterial eingebettet sein, welches beispielsweise ein gleiches Material seinkann wie das, aus dem der Abdeckkörper 6 gefertigt ist. Durch die gleichen Materialien und somit gleichen Brechungsindizes können Reflexionen von elektromagnetischen Strahlen an der Grenzfläche zwischen der Konversionsschicht 3 und dem Abdeckkörper 6 weitestgehend vermieden werden.
Als Material für den Abdeckkörper 6 und/oder das Matrixmaterial der Konversionsschicht 3 sind Gläser geeignet, z.B. ein Borosilikatglas. Das Borosilikatglas kann aufgrund seiner genauen Zusammensetzung einen thermischen Ausdehnungskoeffizient aufweisen, der an den Ausdehnungskoeffizienten des Halbleiterkörpers 20 angepaßt ist, d.h. daß das Matrixmaterial der Konversionsschicht 3 einen gleichen oder zumindest ähnlichen Ausdehnungskoeffizienten aufweist wie Schichten des Halbleiterkörpers 20.
Die Halbleiterschichtenfolge 1 weist auf ihrer Oberfläche einen elektrisch leitfähigen Kontakt sowie ein Bondpad 10 auf, an dem ein Bonddraht 11 angelötet ist, mittels dem die Halbleiterschichtenfolge 1 von einer Seite her mit einer Spannungsquelle elektrisch leitend angeschlossen sein kann. Der Bonddraht 11 gehört dabei jedoch nicht zum Lumineszenzdiodenchip selbst.
Um eine möglichst große durchgehende Fläche für das Aufbringen des Abdeckkörpers 6 auf der Halbleiterschichtenfolge 1 freizulassen, ist das Bondpad 10 an einem Rand der Strahlungsauskoppelfläche 2 angeordnet. Alternativ ist es auch möglich, dass der Abdeckkörper 6 und die Verbindungsschicht 30 in der Mitte mit einem Loch versehen sind und daß das Bondpad 10 in der Mitte der Strahlungsauskoppelfläche 2 angeordnet ist, wie das in der Regel der Fall ist. Dadurch kann eine symmetrischere Beaufschlagung des Halbleiterkörpers 20 mit elektrischem Strom erreicht werden.
Eine weitere Möglichkeit ist, den Halbleiterkörper 20 für eine Flipchip Montage vorzusehen, so daß alle elektrischen Anschlußflächen auf der Halbleiterschichtenfolge ausgebildet sind und die Strahlungsauskoppelfläche eine auf der gegenüberliegenden Seite liegende Fläche eines Substrats des Halbleiterkörpers 20 ist. Bei einem Flipchip ist die Strahlungsauskoppelfläche frei von jeglichem Kontaktmaterial. Ein Bauelement mit einem Flip-Chip ist beispielsweise in der WO 01/47039 A1 offenbart. Die in den Figuren 1 bis 5 dargestellten Lumineszenzdiodenchips unterscheiden sich jeweils durch ihre unterschiedlich geformten Abdeckkörper 6.
Der Abdeckkörper 6 des in Figur 2 dargestellten Lumineszenzdiodenchips weist ebenso wie der in Figur 1 dargestellte Abdeckkörper 6 Seitenflächen 9 auf, die schräg zu einer Haupterstreckungsebene des Abdeckkörpers 6 verlaufen. Ein Unterschied zwischen diesen Abdeckkörpern ist jedoch, daß der in Figur 2 dargestellte eine zweite Hauptfläche 8 aufweist, die nicht parallel zu einer Haupterstreckungsebene des Abdeckkörpers 6 verläuft, sondern linsenartig nach außen gewölbt ist. Dadurch wird eine verbesserte Strahlungsauskopplung sowie eine weitere Strahlformung erreicht.
Eine alternative Ausformung der zweiten Hauptfläche 8 des Abdeckkörpers 6 ist in Figur 3 dargestellt. Die zweite Hauptfläche 8 weist hier die Form einer TIR-Linse (Total Internal Reflection-Linse) auf, deren Strukturen eine Strahlformung mittels interner Totalreflexion bewirken.

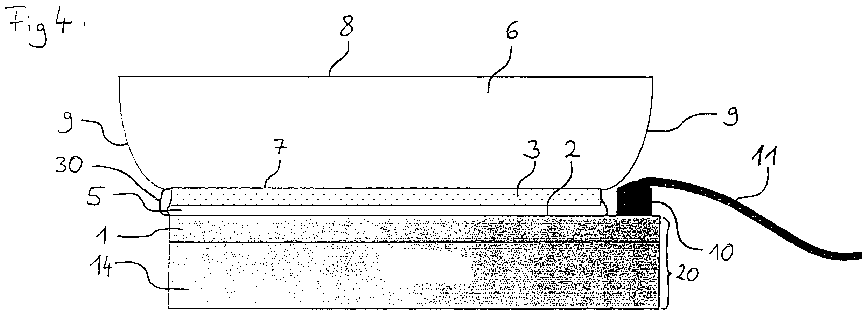

Der Abdeckkörper 6 des in Figur 4 dargestellten Lumineszenzdiodenchips weist keine ebenen, sondern parabolisch geformte Seitenflächen 9 auf. Insgesamt weist dieser Abdeckkörper 6 die Form eines CPC-artigen optischen Konzentrators auf, der in umgekehrter Richtung zum Verringern der Divergenz der von der Halbleiterschichtenfolge 1 emittierten Strahlung verwendet wird.

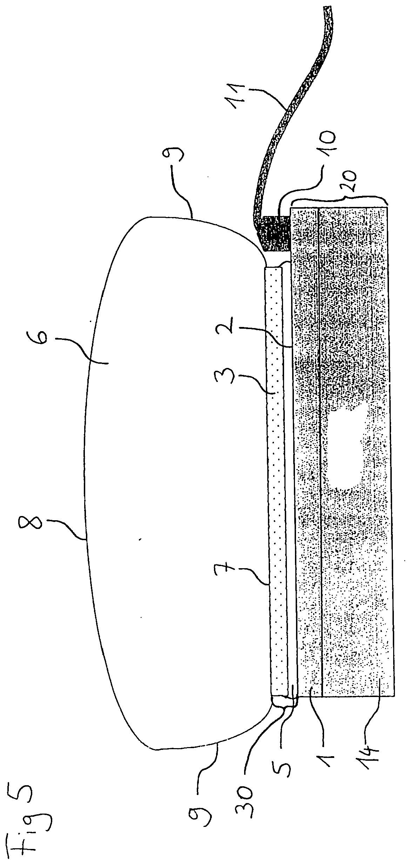

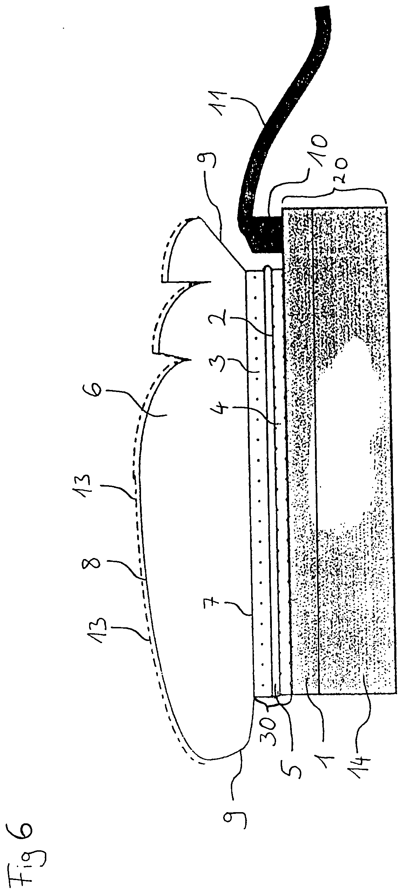

Auch hier ist es möglich, durch eine besondere Ausgestaltung der zweiten Hauptfläche 8 eine weitere Strahlformung zu bewirken. So kann die zweite Hauptfläche 8 wie in Figur 5 dargestellt linsenartig nach außen gewölbt gebildet sein oder wie in Figur 6 dargestellt eine Struktur aufweisen, die eine Strahlformung mittels interner Totalreflexion bewirkt.

In Figur 6 sind die Seitenflächen 9 des Abdeckkörpers 6 zudem teilweise gewölbt und teilweise eben ausgebildet. Darüber hinaus weist die zweite Hauptfläche 8 des in Figur 6 dargestellten Abdeckkörpers diffraktive Oberflächenstrukturen 13 auf, die durch die gestrichelte Linie symbolisch dargestellt sind. Durch derartige diffraktive Strukturen kann eine weitere Strahlformung und/oder eine verbesserte Strahlungsauskopplung bzw. verminderte Reflektivität der zweiten Hauptfläche 8 bewirkt werden. Wenn der Abdeckkörper 6 z.B. aus einem geeigneten Kunststoff gefertigt ist, lassen sich die diffraktiven Strukturen etwa durch Heißprägen erzeugen.

Zusätzlich oder alternativ zu den vorhergehend genannten Gestaltungsmöglichkeiten des Abdeckkörpers 6 kann dieser auch mit holographischen Strukturen oder Elementen versehen sein.

Im Gegensatz zu den in den Figuren 1 bis 5 dargestellten Lumineszenzdiodenchips weist der in Figur 6 dargestellte eine zweite Konversionsschicht 4 auf.

Das Lumineszenz-Konversionsmaterial der zweiten Konversionsschicht 4 kann gleich sein wie das der ersten Konversionsschicht 3. Bringt man bei der Herstellung des Lumineszenzdiodenchips zunächst die zweite Konversionsschicht 4 auf und mißt nachfolgend den Farbort des Lumineszenzdiodenchips, so kann man durch eine gezielte Wahl der Menge von Lumineszenz-Konversionsmaterial in der ersten Konversionsschicht 3 eine Feinabstimmung des Farbortes des resultierenden Lumineszenzdiodenchips durchführen. Alternativ ist es jedoch auch möglich, daß die erste und die zweite Konversionsschicht 3, 4 unterschiedliche Lumineszenz-Konversionsmaterialien mit beispielsweise unterschiedlichen Leuchtstoffen aufweisen.

Zusätzlich oder alternativ kann man den Abdeckkörper 6 selbst aus einem Material bilden, das mit einem Lumineszenz-Konversionsmaterial versetzt ist. Somit bietet das erfindungsgemäße Verfahren insgesamt eine Vielzahl an Möglichkeiten zur Gestaltung des resultierenden Farbortes des Lumineszenzdiodenchips.

Bei den in den Figuren 1 bis 6 dargestellten Lumineszenzdiodenchip ist jeweils auf der ersten Hauptfläche 7 des Abdeckkörpers 6 eine Konversionsschicht 3 aufgebracht. Es ist jedoch ebenso möglich, nur Konversionsschicht auf der Strahluingsauskoppelfläche 2 des Halbleiterkörpers 20 aufzubringen.

Zusätzlich kann auch eine Konversionsschicht auf der zweiten Hauptfläche 8 des Abdeckkörpers 6 aufgebracht sein, so daß diese Konversionsschicht nicht zwischen dem Abdeckkörper 6 und dem Halbleiterkörper 20 sondern auf der von dem Halbleiterkörper 20 abgewandten Seite des Abdeckkörpers 6 angeordnet ist. Lumineszenz-Konversionsmaterialien verschiedener Konversionsschichten können jeweils zumindest teilweise gleich oder unterschiedlich sein.

Die Lumineszenzdiodenchips eignen sich insbesondere auch für die Herstellung von Autoscheinwerfern, wie sie in der deutschen Patentanmeldung 10314524.9 beschrieben sind. Der Schutzumfang der Erfindung ist nicht durch die Beschreibung der Erfindung anhand der Ausführungsbeispiele beschränkt. So ist es beispielsweise möglich, daß die zweite Konversionsschicht nicht nur auf die Strahlungsauskoppelfläche des Halbleiterkörpers sondern auch auf Seitenflächen von diesem aufgebracht wird, so dass auch seiltich aus dem Halbleiterkörper ausgekoppelte elektromagnetische Strahlung in eine Strahlung veränderter Wellenlänge konvertiert wird. Zudem ist es möglich, daß der Übergang von den Seitenflächen des Abdeckkörpers zu der zweiten Hauptfläche nicht klar definierbar ist sondern daß vielmehr die zweite Hauptfläche fließend in die Seitenflächen übergeht oder auch direkt an die erste Hauptfläche angrenzt.

## Patentansprüche

1. Lumineszenzdiodenchip mit einem strahlungsdurchlässigen Abdeckkörper (6) und mit einem Halbleiterkörper (20), der eine epitaktisch gewachsene Halbleiterschichtenfolge (1) mit einer aktiven Zone und eine Strahlungsauskoppelfläche (2) aufweist, wobei die aktive Zone bei Betrieb des Lumineszenzdiodenchips eine elektromagnetische Strahlung emittiert, die zu einem Großteil über die Strahlungsauskoppelfläche (2) ausgekoppelt wird,
- wobei der strahlungsdurchlässige Abdeckkörper (6) der Strahlungsauskoppelfläche (2) in einer Abstrahlrichtung des Lumineszenzdiodenchips nachgeordnet ist und eine der Strahlungsauskoppelfläche (2) zugewandte erste Hauptfläche (7), eine der Strahlungsauskoppelfläche (2) abgewandte zweite Hauptfläche (8) sowie die erste und die zweite Hauptfläche verbindende Seitenflächen (9) aufweist;
- wobei zwischen der Strahlungsauskoppelfläche (2) und dem Abdeckkörper (6) eine Verbindungsschicht (30) angeordnet ist, die den Abdeckkörper (6) direkt mit der Halbleiterschichtenfolge (1) verbindet und ihn an dieser befestigt; und
- wobei die Verbindungsschicht (30) mindestens eine Konversionsschicht (3) mit einem Lumineszenz-Konversionsmaterial und eine Klebstoffschicht umfasst, die zwischen der Konversionsschicht (3) und der Strahlungsauskoppelfläche (2) angeordnet ist und die aus einem auf Silikon basierenden Klebstoff (5) gebildet ist,
**dadurch gekennzeichnet, dass** die Dicke der Verbindungsschicht (30) maximal 200 µm beträgt.

2. Lumineszenzdiodenchip nach Anspruch 1,
**dadurch gekennzeichnet, dass**
die Dicke der Verbindungsschicht (30) maximal 80 µm beträgt.

3. Lumineszenzdiodenchip nach einem der vorhergehenden Ansprüche,
**dadurch gekennzeichnet, dass**
der Abdeckkörper (6) als strahlungsformendes optisches Element ausgebildet ist.

4. Lumineszenzdiodenchip nach einem der vorhergehenden Ansprüche,
**dadurch gekennzeichnet, dass**
der Abdeckkörper (6) als Abdeckplatte ausgebildet ist, dessen Seitenflanken zumindest teilweise nicht senkrecht zur Haupterstreckungsebene der Abdeckplatte verlaufen.

5. Lumineszenzdiodenchip nach einem der vorhergehenden Ansprüche,
**dadurch gekennzeichnet, dass** Seitenflächen des Abdeckkörpers (6) im Wesentlichen parabolisch, hyperbolisch oder elliptisch gekrümmt sind.

6. Lumineszenzdiodenchip nach einem der vorhergehenden Ansprüche,
**dadurch gekennzeichnet, dass**
der Abdeckkörper (6) als optischer Konzentrator ausgebildet ist, der reflektierende Seitenflächen aufweist, die zumindest teilweise die Form eines zusammengesetzten parabolischen Konzentrators, eines zusammengesetzten elliptischen Konzentrators und/oder eines zusammengesetzten hyperbolischen Konzentrators aufweisen, wobei die erste Hauptfläche (7) des Abdeckkörpers (6) der eigentliche Konzentratorausgang ist, so dass Strahlung, verglichen mit der üblichen Anwendung eines Konzentrators zum Fokussieren, in umgekehrter Richtung durch diesen läuft und somit nicht konzentriert wird, sondern den Abdeckkörper (6) mit verringerter Divergenz durch die zweite Hauptfläche (8) verlässt.

7. Lumineszenzdiodenchip nach einem der vorhergehenden Ansprüche,
**dadurch gekennzeichne**t, dass
die zweite Hauptfläche (8) des Abdeckkörpers (6) zumindest teilweise wie eine refraktive und/oder diffraktive Linse gekrümmt bzw. strukturiert ist.

8. Lumineszenzdiodenchip nach einem der vorhergehenden Ansprüche,
**dadurch gekennzeichnet, dass**
der Abdeckkörper (6) holographische Strukturen oder Elemente aufweist.

9. Lumineszenzdiodenchip nach einem der vorhergehenden Ansprüche,
**dadurch gekennzeichnet, dass**
zumindest die Seitenflächen (9) des Abdeckkörpers (6) zumindest teilweise mit einer Schicht oder Schichtenfolge (12), bevorzugt mit einer metallischen Schicht versehen sind, die für eine von dem Lumineszenzdiodenchip ausgesandte Strahlung reflektierend ist.

10. Lumineszenzdiodenchip nach einem der vorhergehenden Ansprüche,
**dadurch gekennzeichnet, dass**
der Abdeckkörper (6) mit einem Lumineszenz-Konversionsmaterial versetzt ist.

11. Lumineszenzdiodenchip nach einem der vorhergehenden Ansprüche,
**dadurch gekennzeichnet, dass**
der Abdeckkörper (6) aus einem Material besteht, dessen Ausdehnungskoeffizient dem Ausdehnungskoeffizienten eines Materials der Halbleiterschichtenfolge (1) entspricht.

12. Lumineszenzdiodenchip nach Anspruch 11,
**dadurch gekennzeichnet, dass**
der Abdeckkörper (6) aus einem Borosilicatglas besteht.

13. Lumineszenzdiodenchip nach einem der vorhergehenden Ansprüche,
**dadurch gekennzeichnet, dass**
die erste Hauptfläche (7) des Abdeckkörpers (6) glatt ausgebildet ist und die Strahlungsauskoppelfläche (2) aufgeraut ist.

14. Lumineszenzdiodenchip nach einem der vorhergehenden Ansprüche,
**dadurch gekennzeichnet, dass** der
Lumineszenzdiodenchip ein Dünnfilm-Lumineszenzdiodenchip ist.

15. Lumineszenzdiodenchip nach einem der Ansprüche 1 bis 13,
**dadurch gekennzeichnet, dass**
der Lumineszenzdiodenchip für eine Flip-Chip-Montage vorgesehen ist.

## Claims

1. Luminescence diode chip with a radiation-transmissive covering body (6) and with a semiconductor body (20) having an epitaxially grown semiconductor layer sequence (1) with an active zone and a radiation coupling-out area (2), the active zone emitting an electromagnetic radiation during operation of the luminescence diode chip, a large part of said electromagnetic radiation being coupled out via the radiation coupling-out area (2),
- wherein the radiation-transmissive covering body (6) is arranged downstream of the radiation coupling-out area (2) in an emission direction of the luminescence diode chip and has a first main area (7) facing the radiation coupling-out area (2), a second main area (8) remote from the radiation coupling-out area (2) as well as side areas (9) connecting the first and second main areas;
- wherein a connecting layer (30) is arranged between the radiation coupling-out area (2) and the covering body (6), which connecting layer (30) directly connects the covering body (6) to the semiconductor layer sequence (1) and fixes it thereto; and
- wherein the connecting layer (30) comprises at least one conversion layer (3) with a luminescence conversion material and an adhesive layer, which is arranged between the conversion layer (3) and the radiation coupling-out area (2) and which is made of a silicone-based adhesive (5),
**characterized in that** the thickness of the connecting layer (30) is at most 200 µm.

2. The luminescence diode chip according to claim 1,
**characterized in that**
the thickness of the connecting layer (30) is at most 80 µm.

3. The luminescence diode chip according to one of the preceding claims,
**characterized in that**
the covering body (6) is formed as a radiation-shaping optical element.

4. The luminescence diode chip according to one of the preceding claims,
**characterized in that**
the covering body (6) is formed as a covering plate whose sidewalls, at least in part, do not run perpendicularly to the main plane of extent of the covering plate.

5. The luminescence diode chip according to one of the preceding claims,
**characterized in that**
side areas of the covering body (6) are essentially parabolically, hyperbolically or elliptically curved.

6. The luminescence diode chip according to one of the preceding claims,
**characterized in that**
the covering body (6) is formed as optical concentrator, which comprises reflecting side areas which at least partly comprise the shape of a compound parabolic concentrator, a compound elliptic concentrator and/or a compound hyperbolic concentrator, the first main area (7) of the covering body (6) being the actual concentrator output, so that radiation, compared with the customary application of a concentrator for focusing, passes through the latter in the opposite direction and is thus not concentrated, but rather leaves the covering body (6) with reduced divergence through the second main area (8).

7. The luminescence diode chip according to one of the preceding claims,
**characterized in that**
the second main area (8) of the covering body (6), at least in part, is curved or structured like a refractive and/or diffractive lens.

8. The luminescence diode chip according to one of the preceding claims,
**characterized in that**
the covering body (6) has holographic structures or elements.

9. The luminescence diode chip according to one of the preceding claims,
**characterized in that**
at least the side areas (9) of the covering body (6), at least in part, are provided with a layer or layer sequence (12), preferably with a metallic layer, which is reflective with respect to a radiation emitted by the luminescence diode chip.

10. The luminescence diode chip according to one of the preceding claims,
**characterized in that**
the covering body (6) is admixed with a luminescence conversion material.

11. The luminescence diode chip according to one of the preceding claims,
**characterized in that**
the covering body (6) consists of a material whose expansion coefficient corresponds to the expansion coefficient of a material of the semiconductor layer sequence (1).

12. The luminescence diode chip according to claim 11,
**characterized in that**
the covering body (6) consists of a borosilicate glass.

13. The luminescence diode chip according to one of the preceding claims,
**characterized in that**
the the first main area (7) of the covering body (6) is formed in a smooth fashion and the radiation coupling-out area (2) is roughened.

14. The luminescence diode chip according to one of the preceding claims,
**characterized in that**
the luminescence diode chip is a thin-film luminescence diode chip.

15. The luminescence diode chip according to one of claims 1 to 13,
**characterized in that**
the luminescence diode chip is provided for flip-chip mounting.

## Revendications

1. Puce de diode luminescente avec un corps de recouvrement perméable au rayonnement (6) et avec un corps de semiconducteur (20), qui présente une succession de couches de semiconducteurs (1) formées par croissance épitaxiale avec une zone active et une surface de découplage du rayonnement (2), la zone active émettant un rayonnement électromagnétique lors du fonctionnement de la puce de diode luminescente, qui est découplé en grande partie via la surface de découplage du rayonnement (2),
- le corps de recouvrement perméable au rayonnement (6) étant monté en aval de la surface de découplage du rayonnement (2) dans un sens de rayonnement de la puce de diode luminescente et présentant une première surface principale (7) tournée vers la surface de découplage du rayonnement (2), une seconde surface principale (8) détournée de la surface de découplage du rayonnement (2) ainsi que des surfaces latérales (9) reliant la première et la seconde surface principale ;
- une couche de liaison étant disposée (30) entre la surface de découplage du rayonnement (2) et le corps de recouvrement (6), qui relie directement le corps de recouvrement (6) avec la succession de couches de semiconducteurs et le fixe sur celle-ci ; et
- la couche de liaison (30) comportant au moins une couche de conversion (3) avec un matériau de conversion de la luminescence et une couche de colle, qui est disposée entre la couche de conversion (3) et la surface de découplage du rayonnement (2) et qui est constituée d'une colle (5) à base de silicone,
**caractérisée en ce que** l'épaisseur de la couche de liaison (30) s'élève à un maximum de 200 µm.

2. Puce de diode luminescente selon la revendication 1,
**caractérisée en ce que**
l'épaisseur de la couche de liaison (30) s'élève à un maximum de 80 µm.

3. Puce de diode luminescente selon une quelconque des revendications précédentes,
**caractérisée en ce que**
le corps de recouvrement (6) est constitué comme élément optique formateur de rayonnement.

4. Puce de diode luminescente selon une quelconque des revendications précédentes,
**caractérisée en ce que**
le corps de recouvrement (6) est constitué comme plaque de recouvrement dont les flancs latéraux se produisent au moins partiellement de manière non verticale par rapport au plan d'extension principal de la plaque de recouvrement.

5. Puce de diode luminescente selon une quelconque des revendications précédentes,
**caractérisée en ce que**
des surfaces latérales du corps de recouvrement (6) sont courbées pour l'essentiel paraboliquement, hyperboliquement ou elliptiquement.

6. Puce de diode luminescente selon une quelconque des revendications précédentes,
**caractérisée en ce que**
le corps de recouvrement (6) est constitué comme concentrateur optique qui présente des surfaces latérales réfléchissantes, qui présentent au moins partiellement la forme d'un concentrateur parabolique composé, d'un concentrateur elliptique composé et/ou d'un concentrateur hyperbolique composé, la première surface principale (7) du corps de recouvrement (6) étant la sortie de concentrateur effective, de sorte que le rayonnement, comparé à l'application habituelle d'un concentrateur en vue de la mise au point, circule en sens inverse à travers celui-ci et n'est donc pas concentré, mais quitte le corps de recouvrement (6) par la seconde surface principale avec une divergence réduite.

7. Puce de diode luminescente selon une quelconque des revendications précédentes,
**caractérisée en ce que**
la seconde surface principale (8) du corps de recouvrement est structurée et/ou courbée au moins partiellement comme une lentille réfractive et/ou diffractive.

8. Puce de diode luminescente selon une quelconque des revendications précédentes,
**caractérisée en ce que**
le corps de recouvrement (6) présente des structures ou des éléments holographiques.

9. Puce de diode luminescente selon une quelconque des revendications précédentes,
**caractérisée en ce que**
au moins les surfaces latérales (9) du corps de recouvrement (6) sont dotées au moins partiellement d'une couche ou d'une suite de couches (12), de préférence d'une couche métallique, qui est réfléchissante pour un rayonnement émis pour la puce de diode luminescente.

10. Puce de diode luminescente selon une quelconque des revendications précédentes,
**caractérisée en ce que**
le corps de recouvrement (6) est déplacé avec un matériau de conversion à luminescence.

11. Puce de diode luminescente selon une quelconque des revendications précédentes,
**caractérisée en ce que**
le corps de recouvrement (6) se compose d'un matériau, dont le coefficient de dilatation correspond au coefficient de dilatation d'un matériau de la succession de couches de semiconducteurs (1).

12. Puce de diode luminescente selon la revendication 11,
**caractérisée en ce que**
le corps de recouvrement (6) se compose d'un verre au borosilicate.

13. Puce de diode luminescente selon une quelconque des revendications précédentes,
**caractérisée en ce que**
la première surface principale (7) du corps de recouvrement (6) est constituée de manière lisse et la surface de découplage du rayonnement (2) est grattée.

14. Puce de diode luminescente selon une quelconque des revendications précédentes,
**caractérisée en ce que**
la puce de diode luminescente est une puce de diode luminescente à film fin.

15. Puce de diode luminescente selon une quelconque des revendications 1 à 13,
**caractérisée en ce que**
la puce de diode luminescente est prévue pour un montage en flip-chip.
